(19) Europäisches Patentamt
European Patent Office
Office européen des brevets

(11) **EP 4 624 891 A1**

(12) **EUROPEAN PATENT APPLICATION**
published in accordance with Art. 153(4) EPC

(43) Date of publication:
01.10.2025 Bulletin 2025/40

(21) Application number: 23919286.7

(22) Date of filing: 20.07.2023

(51) International Patent Classification (IPC):
*G01M 11/06* (2006.01)   *G01R 31/44* (2020.01)
*G01R 1/04* (2006.01)

(52) Cooperative Patent Classification (CPC):
Y02B 20/40

(86) International application number:
**PCT/CN2023/108302**

(87) International publication number:
**WO 2024/159721 (08.08.2024 Gazette 2024/32)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 31.01.2023  CN 202310046872

(71) Applicant: **Changzhou Xingyu Automotive
Lighting
Systems Co., Ltd.
Changzhou, Jiangsu 213022 (CN)**

(72) Inventors:
• **WU, Jie
Changzhou, Jiangsu 213022 (CN)**
• **ZHU, Tao
Changzhou, Jiangsu 213022 (CN)**

(74) Representative: **Behr, Wolfgang
Lorenz Seidler Gossel
Rechtsanwälte Patentanwälte
Partnerschaft mbB
Widenmayerstraße 23
80538 München (DE)**

(54) **LUMINOSITY COMPENSATION METHOD FOR TESTING OPTICAL PERFORMANCE OF LAMP**

(57)    Disclosed in the present invention is a luminosity compensation method for testing optical performance of a lamp. The method includes: S1: acquiring reference test data Data1 from a standard-compliant lamp; S2: acquiring actual test data Data2 of a lamp under test; S3: fitting and aligning the reference test data Data1 and the actual test data Data2 to acquire a preliminary data position in the reference test data Data1 that best matches the actual test data Data2; S4: performing position compensation on the preliminary data position to acquire a final data position; and S5: determining a final luminosity value of the lamp under test according to the final data position. The present invention can shorten the test time to improve the production line test efficiency and meet production requirements, and can also reduce the impact of heat accumulation on the test result to improve the accuracy of the test result.

Acquire reference test data Data1 of a standard-compliant lamp — S1

Acquire actual test data Data2 of a lamp under test — S2

Fit and align the reference test data Data1 and the actual test data Data2 to obtain a preliminary data position in the reference test data Data1 that best matches the actual test data Data2 — S3

Perform position compensation on the preliminary data position to obtain a final data position — S4

Determine a final luminosity value of the lamp under test according to the final data position — S5

FIG. 1

**Description**

**TECHNICAL FIELD**

The present invention relates to the technical field of lamp testing, and specifically to a luminosity compensation method for testing optical performance of a lamp.

**BACKGROUND**

Vehicle lights are tools providing illumination for vehicles driving on the road at night, and can also be used to send various vehicle driving signals. Vehicle lights generally include headlights, taillights, turn signal lights, fog lights, etc. A vehicle light manufactured in a factory needs to be tested for its performance (e.g., optical performance, sealing performance, etc.) before delivery. As stipulated in regulations, during the optical testing of the vehicle light, the measurement should not be performed unless luminosity data becomes stable. Generally, a lamp can reach a thermally stable state after being lit up for 30 minutes, which significantly prolongs the test time and affects the test efficiency. Especially in the design verification stage, the design needs to be modified and verified multiple times. With the increasing number of projects, the testing apparatus of vehicle lighting companies cannot meet the testing needs.

In addition, per production process specifications, automotive lamps must undergo high-temperature stress-relief baking, electrical testing, and other pre-optical procedures prior to optical performance assessment. For example, high-temperature baking leads to heat accumulation inside the vehicle light. If the optical performance of the lamp is tested immediately after high-temperature baking, the heat accumulation affects the test accuracy. If the vehicle light is placed at other working positions for heat dissipation and cooling, a cooling device (e.g., a fan) needs to be used, leading to an increase in both the test time and cost. For example, the electrical test requires the vehicle light to be lit for 20 seconds, which also leads to heat accumulates inside the vehicle light and thus affects the accuracy of subsequent light intensity detection. Therefore, it is necessary to propose a novel testing method that can reduce the impact of heat accumulation on the test result and improve the test efficiency.

**SUMMARY**

An objective of the present invention is to provide a luminosity compensation method for testing optical performance of a lamp, in order to solve the technical problem of the impact of heat accumulation on the light intensity test of a lamp. The luminosity compensation method can shorten the test time to improve the production line test efficiency and meet production requirements, and can also reduce the impact of heat accumulation on the test result to improve the accuracy of the test result.

To solve the above technical problems, the following technical solutions are employed in the present invention. A luminosity compensation method for testing optical performance of a lamp is provided. The method includes:

step S1: acquiring reference test data Data1 from a standard-compliant lamp;
step S2: acquiring actual test data Data2 of a lamp under test;
step S3: fitting and aligning the reference test data Data1 and the actual test data Data2 to acquire a preliminary data position in the reference test data Data1 that best matches the actual test data Data2;
step S4: performing position compensation on the preliminary data position to acquire a final data position; and
step S5: determining a final luminosity value of the lamp under test according to the final data position.

Further, the step S1 of acquiring the reference test data Data1 from the standard-compliant lamp further includes:

performing continuous measurement on benchmark luminosity data of the standard-compliant lamp until the standard-compliant lamp reaches a stable state, and acquiring a benchmark luminosity attenuation curve of the standard-compliant lamp;
normalizing the benchmark luminosity attenuation curve and calculating benchmark gradient data of each data point on the benchmark luminosity attenuation curve; and
determining the benchmark gradient data as the reference test data Data1.

Further, the step S2 of acquiring the actual test data Data2 of the lamp under test further includes:

performing continuous measurement on the lamp under test to acquire a set of actual luminosity data, normalizing the actual luminosity data, and calculating actual gradient data of each data point in the actual luminosity data; and
determining the actual gradient data as the actual test data Data2.

Further, for the continuous measurement of the standard-compliant lamp until the standard-compliant lamp reaches the stable state, a measurement time $t_1$ is at least 30 minutes, and a measurement interval $\Delta t_1$ is less than 1 second; and for the continuous measurement of the lamp under test, a measurement time $t_2$ is at least 20 seconds, and a measurement interval $\Delta t_2$ is equal to the measurement interval $\Delta t_1$ for the standard-compliant lamp.

Further, normalizing the benchmark luminosity attenuation curve includes:

removing a first item $E_{bench\,1}$ collected of the benchmark luminosity data, and normalizing remaining items $E_{bench\,2}$ to $E_{benchh}$ of the benchmark luminosity data using the following formula:

$$E_{bench-norm_{n-1}} = E_{bench\,n} \Big/ E_{bench\,2}$$

where $E_{bench\text{-}norm\,n-1}$ represents normalized data, n is a positive integer, $1<n\leq L_1$, and $L_1$ represents a total number of items of the benchmark luminosity data, indicating that a total of $L_1-1$ items of the normalized data are to be acquired; and
calculating the benchmark gradient data of the normalized data using the following formula:

$$G_{bench_N} = E_{bench-norm_{N+2}} - E_{bench-norm_{N+1}}$$

where $G_{bench_N}$ represents an $N^{th}$ item of the benchmark gradient data acquired by the normalized data, and $1\leq N<L_1-1$.

Further, in the step S3, the preliminary data position is calculated using the following formula:

$$Index = \arg\min\left(\Delta G_p\right)$$

where Index represents a time position in the benchmark luminosity attenuation curve, $\Delta G_p$ represents a sum of squares of differences between a gradient data change sequence $G_{[L1/2]}$ to $G_{L1}$ of the actual luminosity data and a benchmark gradient data sequence of a corresponding length at a position p in the benchmark luminosity data, a value of p satisfies $1\leq p<L_1-L_2+1$, and $L_2$ represents a total number of items of the actual luminosity data.

Further, $\Delta G_p$ is calculated using the following formula:

$$\Delta G_p = \sum_{M=[L_1/2]}^{L_1} \left(G_M - G_{bench\,p+M+1}\right)^2$$

where $G_M$ represents the actual gradient data, [] represents a rounding operation, $G_{bench\,p+M+1}$ represents a $(p+M-1)^{th}$ item of the benchmark gradient data acquired by the normalized data, and $G_M$ is expressed as $G_M = E_{normM+1} - E_{normM}$,

where $1<M<L_2$, $E_{norm\,M}$ represents normalized data of the actual luminosity data $E_m$, $\quad E_{norm\,M} = E_m \Big/ E_2$ , m is a positive integer, and $1<m\leq L_2$.

Further, in the step S4, the position compensation is performed on the preliminary data position using the following formula:

$$Index_{compen} = Index + \left[a \times e^{b(\Delta s-c)}\right]$$

where a, b, and c are constants, and $\Delta s$ represents a variable introduced for luminosity compensation and is expressed as:

$$\Delta s = \sum_{m=1}^{L_1} \left( E_m - E_{bench_{Index+m}} \right)$$

where $E_{benchIndex+m}$ represents an (Index+m)$^{th}$ item of the benchmark luminosity data.

Further, after the final data position $Index_{compen}$ is acquired, an actual final luminosity value at a moment T is calculated using the following formula:

$$E_T = \frac{E_{bench_T}}{E_{bench_{Index_{compen}}}} \times E_{last}$$

where $E_T$ represents an actual luminosity value of the lamp under test measured at the moment T, $E_{benchT}$ represents benchmark luminosity data of the standard-compliant lamp at the moment T, $E_{bench_{Index_{compen}}}$ represents benchmark luminosity data of the standard-compliant lamp at the final data position $Index_{compen}$, and $E_{last}$ represents actual luminosity data of the lamp under test acquired by a last measurement among continuous measurements.

The present invention has the following advantages. According to the luminosity compensation method for testing optical performance of a lamp in the present invention, with the introduction of a luminosity attenuation gradient, a short attenuation gradient curve of a lamp under test is aligned with a benchmark attenuation gradient of a standard-compliant lamp to find the most appropriate measurement time position, and then a luminosity value of the lamp under test in a stable state or luminosity values of the lamp under test at other moments are calculated according to the most appropriate measurement time position. As such, the test time can be shortened to improve the production line test efficiency and meet production requirements. In addition, the impact of heat accumulation on the test result can be reduced to improve the accuracy of the test result. Because there is no need to prepare another working position for cooling and heat dissipation of the lamp, the cost can also be reduced.

**BRIEF DESCRIPTION OF THE DRAWINGS**

The present invention will be further described below with reference to the accompanying drawings and embodiments.

FIG. 1 is a flowchart of a luminosity compensation method for testing optical performance of a lamp according to the present invention.

FIG. 2 shows luminosity attenuation curves of different lamps according to the present invention.

FIG. 3 is a schematic diagram of light beams at different positions that are emitted by a lamp according to the present invention.

FIG. 4 shows luminosity attenuation curves of a lamp corresponding to different positions according to the present invention.

FIG. 5 shows luminosity attenuation curves of a lamp before and after baking according to the present invention.

FIG. 6 shows luminosity attenuation curves of a lamp acquired in a case of starting measurement after the lamp has been lit for 5 minutes and in a case of starting measurement immediately after the lamp is lit according to the present invention.

FIG. 7 shows luminosity attenuation curves of different lamps under normal conditions according to the present invention.

FIG. 8 is a schematic diagram of aligning actual gradient data (short line segment) with benchmark gradient data (long curve) according to the present invention.

**DETAILED DESCRIPTION OF THE EMBODIMENTS**

The present invention will be further described in detail below with reference to the accompanying drawings. The drawings are simplified schematic diagrams, and only describe basic structures of the present invention in a schematic manner. Therefore, the drawings show only compositions related to the present invention.

In the description of the present invention, it should be understood that directions or location relationships indicated by the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", and "circumferential" are directions or location relationships shown based on the accompanying drawings, which are merely provided for the purpose of describing the present invention and simplifying the description, but are not used to indicate or imply that a device or an element must have a particular direction, or must be constructed and operated in a particular direction. Therefore, they cannot be construed as limiting on the present invention. In addition, a feature defined by "first" or "second" may explicitly or implicitly include one or more of said features. In the description of the present invention, "multiple" and "a plurality of" mean two or more, unless otherwise particularly defined.

In the description of the present invention, it should be noted that, unless otherwise clearly specified and defined, the terms "mount", "install", "connect", "couple", and variants thereof should be interpreted in a broad sense, for example, may be a fixed connection, a detachable connection, or an integral connection; may be a mechanical connection or an electrical connection; or may be a direct connection, an indirectly connection via an intermediate medium, or communication between the interiors of two components. For those of ordinary skill in the art, the specific meanings of the above terms in the present invention can be understood according to specific circumstances.

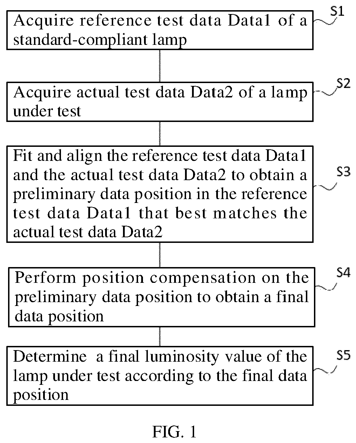

As shown in FIG. 1, a luminosity compensation method for testing optical performance of a lamp according to the present invention includes the following steps.

In step S1, reference test data Data1 from a standard-compliant lamp is acquired.

In step S2, actual test data Data2 of a lamp under test is acquired.

In step S3, the reference test data Data1 and the actual test data Data2 are fitted and aligned to acquire a preliminary data position in the reference test data Data1 that best matches the actual test data Data2.

In step S4, position compensation is performed on the preliminary data position to acquire a final data position.

In step S5, a ratio between the actual test data Data2 and the reference test data Data1 is determined according to the final data position, and a final luminosity value of the lamp under test is acquired according to the ratio.

In other words, according to the present invention, the actual test data can be aligned with the reference test data to find a position in the reference test data that best matches the actual test data, and the final luminosity value of the lamp under test in a stable state can be calculated according to the ratio. As such, the impact of heat accumulation in the lamp on the test result can be reduced, and the test efficiency can be significantly improved.

Specifically, the step S1 of acquiring the reference test data Data1 from the standard-compliant lamp further includes: continuously measuring benchmark luminosity data of the standard-compliant lamp until the standard-compliant lamp reaches a stable state, and acquiring a benchmark luminosity attenuation curve of the standard-compliant lamp; normalizing the benchmark luminosity attenuation curve and calculating benchmark gradient data of each data point on the benchmark luminosity attenuation curve; and determining the benchmark gradient data as the reference test data Data1. It should be noted that for the continuous measurement of the standard-compliant lamp until the standard-compliant lamp reaches the stable state, a measurement time $t_1$ is at least 30 minutes, and a measurement interval $\Delta t_1$ is less than 1 second. A basis for determining whether the stable state is reached is determining whether a change of the luminosity value within 15 minutes is less than 3%. Generally, the lamp can reach the stable state after being lit for 30 minutes, and the measurement interval can be set to 0.5 seconds. According to the collected benchmark luminosity data, a benchmark luminosity attenuation curve (i.e., a curve of the benchmark luminosity data changing with time) can be plotted. As the lighting time of the lamp increases, the luminosity data of the lamp gradually attenuates until the stable state is reached. The luminosity data in the stable state is used to determine whether the optical performance of the lamp meets regulatory requirements. Each data point of the benchmark luminosity attenuation curve is normalized to facilitate subsequent analysis. After the normalization, the benchmark gradient data of each data point in the benchmark luminosity attenuation curve is calculated, i.e., the change trend of the benchmark luminosity attenuation curve can be acquired.

Specifically, the step S2 of acquiring the actual test data Data2 of the lamp under test further includes: continuously measuring the lamp under test to acquire a set of actual luminosity data, normalizing the actual luminosity data, and calculating actual gradient data of each data point in the actual luminosity data; and determining the actual gradient data as the actual test data Data2. It should be noted that for the continuous measurement of the lamp under test, a measurement time $t_2$ is at least 20 seconds, and a measurement interval $\Delta t_2$ is equal to the measurement interval $\Delta t_1$ for the standard-compliant lamp, and is, for example, also set to 0.5 seconds. The continuous measurement time of the lamp under test is much less than that of the standard-compliant lamp. One item of actual luminosity data can be acquired from each luminosity measurement. Assuming that the lamp under test is measured for a total of 30 seconds with an interval of 0.5 seconds, a total of 60 items of actual luminosity data can be acquired. A short luminosity attenuation curve can be plotted according to the 60 items of actual luminosity data. To facilitate analysis, the actual luminosity data is also normalized and the actual gradient data is calculated.

In other words, in this embodiment, the data of the standard-compliant lamp is used as benchmarking data, and the actual data of the lamp under test is aligned with the benchmarking data to acquire a luminosity value of the lamp under test in the stable state. As such, the test time can be reduced to improve the test efficiency, and the impact of heat accumulation caused by other processes on the test result can be reduced to improve the accuracy of the test result.

Specifically, normalizing the benchmark luminosity attenuation curve includes: removing a first item $E_{bench\ 1}$

collected of benchmark luminosity data, and normalizing remaining items $E_{bench2}$ to $E_{bench}$ of the benchmark luminosity data using the following formula:

$$E_{bench-norm\,n-1} = E_{bench\,n} / E_{bench\,2}$$

, where $E_{bench-norm\,n-1}$ represents the normalized data, n is a positive integer, $1<n\leq L_1$, and $L_1$ represents a total number of items of benchmark luminosity data, indicating that a total of $L_1$-1 items of normalized data are to be acquired; and calculating benchmark gradient data of the normalized data using the following formula: $G_{benchN} = E_{bench-normN+2} - E_{bench-normN+1}$, where $G_{benchN}$, represents an $N^{th}$ item of benchmark gradient data acquired by normalizing benchmark data, and $1\leq N<L_1$-1.

It should be noted that the luminosity data is generally collected by a sensor through integral measurement, and the first item of luminosity data collected is relatively small because the lamp has not been turned on in the earlier part of the integration time and the lamp is fully turned on only in the later part of the integration time, so the first item of luminosity data collected is removed during data processing. In this embodiment, for the normalization of the benchmark luminosity data and the actual luminosity data, both the first item of benchmark luminosity data collected and the first item of actual luminosity data collected are removed. It is assumed that $L_1$ items of benchmark luminosity data $E_{bench1}$ to $E_{bench\,L_1}$ are collected by continuous measurement of the standard-compliant lamp, and $L_2$ items of actual luminosity data $E_1$ to $E_{L2}$ are collected by continuous measurement of the lamp under test. During normalization, the first item of benchmark luminosity data $E_{bench1}$ collected and the first item of actual luminosity data $E_1$ collected are removed. The benchmark luminosity data is normalized using the following formula: $E_{bench-norm\,n-1} = E_{bench\,n}/E_{bench\,2}$, where n is a positive integer, and $1<n\leq L1$. The actual luminosity data is normalized using the following formula: $E_{normM} = E_m/E_2$, where $1\leq M<L_2$, $E_{normM}$ represents normalized data of actual luminosity data $E_m$, m is a positive integer, and $1<m\leq L_2$. After the normalized data is acquired, gradient data can be calculated. The gradient data can show the attenuation rate of the luminosity data, which is a basis for aligning the actual luminosity data with the benchmark luminosity data. A gradient of the normalized benchmark data is calculated using a formula $G_{benchN} = E_{bench-normN+2} - E_{bench-nornmN+1}$, and a gradient of the normalized actual data is calculated using a formula $G_M = E_{normM+1} - E_{normM}$. As such, gradient data between two adjacent items of luminosity data can be acquired.

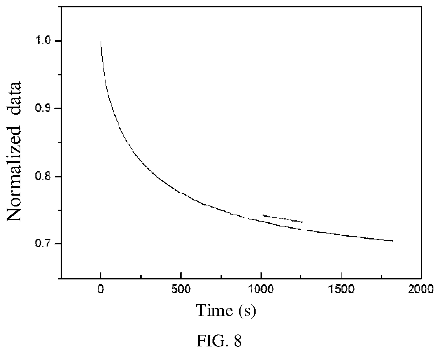

After the benchmark gradient data and the actual gradient data are acquired, the benchmark gradient data and the actual gradient data may be fitted using a least squares method, to find a part of the benchmark gradient data that best matches the actual gradient data, thus finding an optimal data position (as shown in FIG. 8). The preliminary data position is calculated using the following formula: $Index = \arg\min(\Delta_{Gp})$, where Index represents a time position in the benchmark luminosity attenuation curve, $\Delta G_p$ represents a sum of squares of differences between a gradient data change sequence $G_{[L1/2]}$ to $G_{L1}$ of the actual luminosity data and a benchmark gradient data sequence of a corresponding length at a position p in the benchmark luminosity data, a value of p satisfies $1\leq p<L_1-L_2+1$. $\Delta G_p$ is calculated using the following formula:

$$\Delta G_p = \sum_{M=[L_1/2]}^{L_1} \left( G_M - G_{bench\,p+M-1} \right)^2$$

, where $G_m$ represents the actual gradient data, represents a rounding operation, and $G_{bench\,p+M+1}$ represents a $(p+M-1)^{th}$ item of benchmark gradient data acquired by the normalized data. In other words, Index represents a time position found by fitting, at which the benchmark gradient data best matches the actual gradient data. Because the impact of heat on luminosity attenuation is not completely consistent with the impact of time on luminosity attenuation, secondary correction is needed after the preliminary data position Index is acquired. The position compensation is performed on the preliminary data position using the following formula: $Index_{compen} = Index + [a \times e^{b(\Delta s-c)}]$. In this formula, a, b, and c are all constants, which need to be acquired through testing and calibration according to heat dissipation and power of the lamp under test. For example, for a rear fog light, a=10, b=30, and c=0.065. $\Delta s$ represents a variable introduced for luminosity compensation. The value of $\Delta s$ is related to a difference area between the actual measurement data and preliminarily located data in the benchmark data, and is expressed as:

$$\Delta s = \sum_{m=1}^{L_1} \left( E_m - E_{bench\,Index+m} \right)$$

, where $E_{benchIndex+m}$ represents an $(Index+m)^{th}$ item of benchmark luminosity data. Thus, a more accurate time position $Index_{compen}$ can be acquired. After the final data position $Index_{compen}$ is acquired, an actual final luminosity value at a moment T is calculated using the following formula:

$$E_T = \frac{E_{bench\,T}}{E_{bench\,Index\,compen}} \times E_{last}$$

, where $E_T$ represents an actual luminosity value of the lamp under test measured at the moment T, $E_{benchT}$ represents benchmark luminosity data of the standard-compliant lamp at the moment T, $E_{bench_{Index_{compen}}}$ represents benchmark luminosity data of the standard-compliant lamp at the final data position $Index_{compen}$, and $E_{last}$ represents actual luminosity data of the lamp under test acquired by a last measurement among continuous measurements. In other words, after a final position in the benchmark luminosity attenuation curve that corresponds to the actual luminosity data is determined, it can be determined that luminosity data of the lamp under test at a moment $Index_{compen}$ is $E_{bench_{Index_{compen}}}$. In this case, luminosity data of the lamp under test at other moments can be calculated using a formula $E_T = \dfrac{E_{bench\ T}}{E_{bench\ Index\ compen}} \times E_{last}$. For example, luminosity data of the lamp under test in the stable state is expressed as: $E_{3600} = \dfrac{E_{bench\ 3600}}{E_{bench\ Index\ compen}} \times E_{last}$. $E_{3600}$ corresponds to luminosity of the lamp under test after being lit for 30 minutes (i.e., after the lamp under test reaches the stable state).

In other words, in the present invention, the lamp under test does not need to be lit for 30 minutes for testing. Instead, a part of data is collected (e.g., in a measurement that lasts 30 seconds) and is aligned with benchmark data to find a time position in the benchmark data that best matches luminosity attenuation of the collected data, and a stable luminosity value or luminosity values at other moments are calculated using a formula. As such, the present invention not only can significantly reduce the test time to improve the test efficiency and reduce the cost, but also can reduce the impact of heat accumulation on the test result to improve the accuracy of the test result.

Experimental data are provided below to prove the feasibility of the method of the present invention.

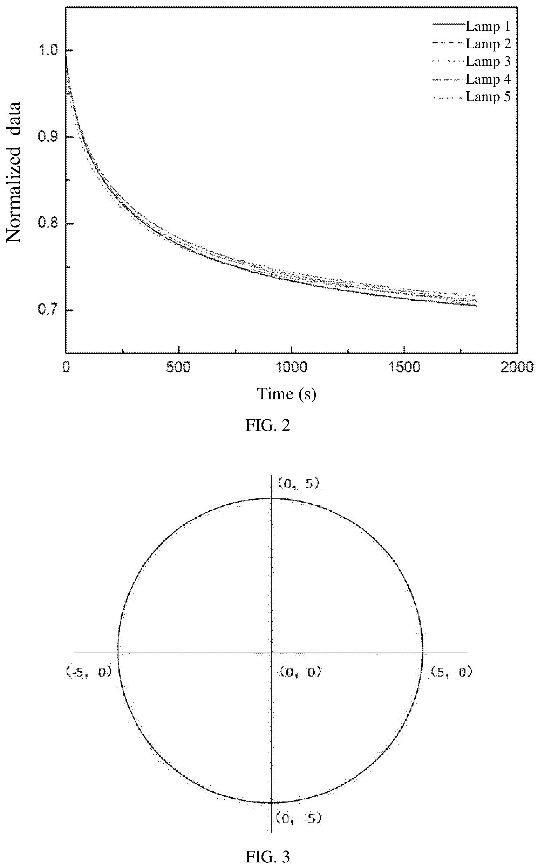

FIG. 2 shows luminosity attenuation curves of four rear fog lights of the same type at position (0, 0), where each of the four rear fog lights was continuously measured for 30 minutes with a measurement interval of 0.5 seconds, and a total of 3600 items of data were acquired. Four luminosity attenuation curves were acquired through normalization with the first item of luminosity data being removed, where the abscissa represents the test time and the ordinate represents the normalized data. As can be seen from the figure, the change trends of the luminosity attenuation curves of the rear fog lights of the same type were substantially the same, and the normalized data gradually decreased with the test time and eventually became stable. Therefore, it is feasible to use test data of a standard-compliant lamp as benchmark data.

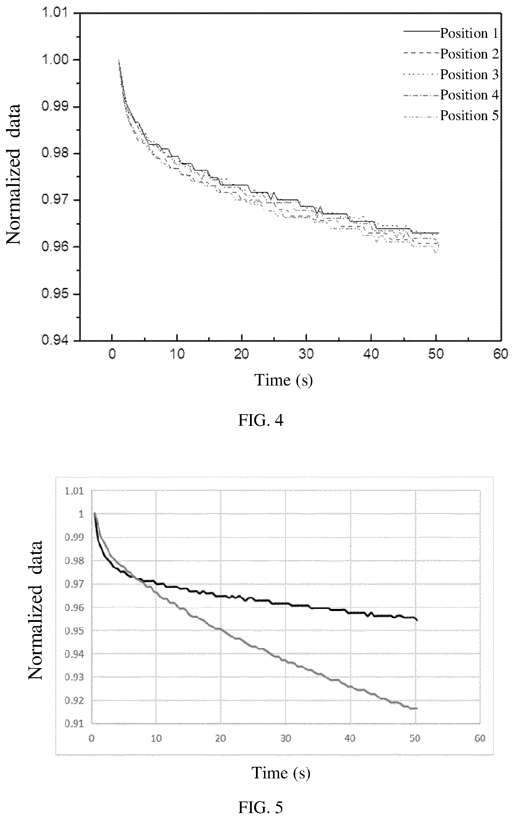

FIG. 4 shows luminosity attenuation curves of a lamp corresponding to different positions. A beam emitted by the lamp was generally conical, with the center point of the beam being at position (0, 0). By respectively shifting the center point of the beam upward, downward, leftward, and rightward by 5°, four other positions (0, 5), (0, -5), (5, 0), and (-5, 0) were acquired (as shown in FIG. 3). The luminosity attenuation of the lamp was respectively measured at the five positions using a test instrument which was placed 1.2 meters in front of the center point of the lamp. By respectively normalizing the measured data, five luminosity attenuation curves were acquired. It can be seen from the figure that the luminosity attenuation trends of the lamp measured at different positions were substantially the same.

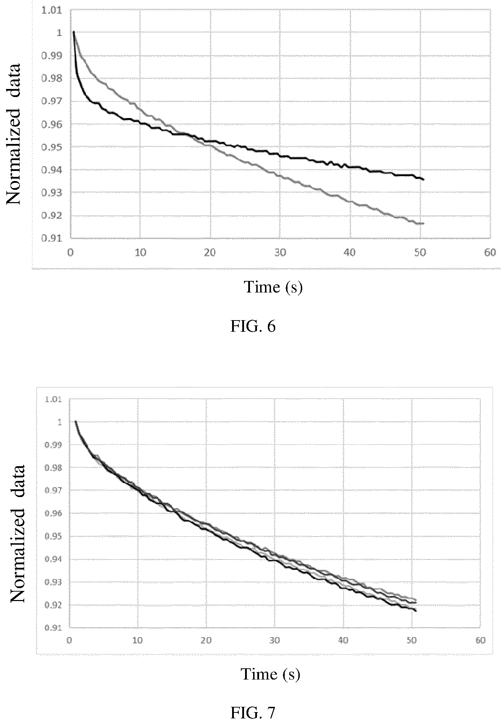

FIG. 5 shows luminosity attenuation curves of a rear fog light acquired without baking and after baking at a high temperature in an oven for 30 minutes, where a black curve represents an attenuation curve of the lamp acquired after high-temperature baking, and a gray curve represents an attenuation curve of the lamp acquired at normal temperature without baking. FIG. 6 shows luminosity attenuation curves of a lamp acquired in a case of starting measurement after the lamp has been lit for 5 minutes and in a case of starting measurement immediately after the lamp is lit, where a black curve represents an attenuation curve of the lamp acquired in the case of starting measurement after the lamp has been lit for 5 minutes, and a gray curve represents an attenuation curve of the lamp acquired at normal temperature in the case of starting measurement immediately after the lamp is lit. It can be seen from FIG. 5 and FIG. 6 that the light intensity of the lamp with heat accumulation attenuated quickly in the first 8 seconds, and then the attenuation rate decreased sharply, indicating that heat accumulation had a great impact on the measured luminosity of the lamp and seriously affected the accuracy of the test result. FIG. 7 shows attenuation curves of different lamps (respectively corresponding to 4 curves) lit at room temperature (without heat accumulation) for 50 seconds. It can be seen from FIG. 7 that the differences between the attenuation curves of the different lamps without heat accumulation were small.

Test data of a standard-compliant rear fog light at position (0, 0) was selected as benchmark data, and then three rear fog lights A, B, and C of the same type were selected to verify the effect of the method of the present invention. The three rear fog lights A, B, and C were respectively tested at positions (0, 0), (0, 5), and (5, 0) by using a conventional test method and the test method of the present invention, and the light intensities of the lamps were recorded. The test results are shown in Table 1 to Table 3. It can be seen from the results in the three tables that the conventional method failed to compensate for the error caused by heat accumulation, and long-time lighting or long-time high-temperature oven baking of the lamp significantly affected the test accuracy, with a maximum error of up to -17%; while the maximum error of the compensation method of the present invention was -2.8%, showing that the present invention can significantly improve the test accuracy and reduce the test error for lamps with heat accumulation.

Table 1 Test results of rear fog light A

| Position of measurement | Measured light intensity (cd) | Conventional method (cd) | | Method of the present invention (cd) | |
|---|---|---|---|---|---|
| | | Without heat accumulation | 30 minutes of oven baking | Without heat accumulation | 30 minutes of oven baking |
| (0, 0) | 163 | 165.4 (1.47%) | 139.7 (-14.3%) | 166 (1.84%) | 161.2 (-1.1%) |
| (0, 5) | 187 | 188 (0.53%) | 160 (-14.4%) | 188.7 (0.9%) | 184.1 (-1.5%) |
| (5, 0) | 221 | 222.4 (0.63%) | 189.6 (-14.2%) | 223 (0.9%) | 219.4 (-0.7%) |

Table 2 Test results of rear fog light B

| Position of measurement | Measured light intensity (cd) | Conventional method (cd) | | Method of the present invention (cd) | |
|---|---|---|---|---|---|
| | | Without heat accumulation | 30 minutes of oven baking | Without heat accumulation | 30 minutes of oven baking |
| (0, 0) | 172 | 167.4 (-2.6%) | 142.9 (-16.9%) | 167.8 (-2.4%) | 167.2 (-2.8%) |
| (0, 5) | 191 | 190.9 (-0.05%) | 160.6 (-15.9%) | 187.6 (-1.78%) | 185.1 (-3.1%) |
| (5, 0) | 229 | 224.2 (-2.1%) | 193.2 (-15.6%) | 225.1 (-1.7%) | 226.6 (-1%) |

Table 3 Test results of rear fog light C

| Position of measurement | Measured light intensity (cd) | Conventional method (cd) | | Method of the present invention (cd) | |
|---|---|---|---|---|---|
| | | Without heat accumulation | 30 minutes of oven baking | Without heat accumulation | 30 minutes of oven baking |
| (0, 0) | 159 | 158.5 (-0.3%) | 131.3 (-17.4%) | 159.3 (0.2%) | 154.9 (-2.5%) |
| (0, 5) | 176 | 175.6 (-0.2%) | 149.3 (15.2%) | 176.4 (0.2%) | 172 (-2.3%) |
| (5, 0) | 197 | 197.1 (-0.05%) | 166.3 (-15.6%) | 198.04 (0.5%) | 193.9 (-1.6%) |

To sum up, according to the luminosity compensation method for testing optical performance of a lamp in the present invention, with the introduction of a luminosity attenuation gradient, a short attenuation gradient curve of a lamp under test is aligned with a benchmark attenuation rate of a standard-compliant lamp to find the most appropriate measurement time position, and then a luminosity value of the lamp under test in a stable state or luminosity values of the lamp under test at other moments are calculated according to the most appropriate measurement time position. As such, the test time can be shortened to improve the production line test efficiency and meet production requirements. In addition, the impact of heat accumulation on the test result can be reduced to improve the accuracy of the test result. Because there is no need to prepare another working position for cooling and heat dissipation of the lamp, the cost can also be reduced. The method of the present invention can achieve fast coarse judgment in the design verification stage and meet the requirements on the test accuracy of optical performance of lamps.

Based on the teaching of the above embodiments of the present invention, various changes and modifications can be made by those skilled in the art without departing from the scope of the present invention. The technical scope of the present invention is not limited to the contents of the specification, but shall be subject to the scope of the appended claims.


**Claims**

**1.**  A luminosity compensation method for testing optical performance of a lamp, **characterized by** comprising:

step S1: acquiring reference test data Data1 from a standard-compliant lamp;

step S2: acquiring actual test data Data2 of a lamp under test;

step S3: fitting and aligning the reference test data Data1 and the actual test data Data2 to acquire a preliminary data position in the reference test data Data1 that best matches the actual test data Data2;

step S4: performing position compensation on the preliminary data position to acquire a final data position; and

step S5: determining a final luminosity value of the lamp under test according to the final data position.

2. The luminosity compensation method according to claim 1, **characterized in that** the step S1 of acquiring the reference test data Data1 from the standard-compliant lamp further comprises:

performing continuous measurement on benchmark luminosity data of the standard-compliant lamp until the standard-compliant lamp reaches a stable state, and acquiring a benchmark luminosity attenuation curve of the standard-compliant lamp;

normalizing the benchmark luminosity attenuation curve and calculating benchmark gradient data of each data point on the benchmark luminosity attenuation curve; and

determining the benchmark gradient data as the reference test data Data1.

3. The luminosity compensation method according to claim 2, **characterized in that** the step S2 of acquiring the actual test data Data2 of the lamp under test further comprises:

performing continuous measurement on the lamp under test to acquire a set of actual luminosity data, normalizing the actual luminosity data, and calculating actual gradient data of each data point in the actual luminosity data; and determining the actual gradient data as the actual test data Data2.

4. The luminosity compensation method according to claim 3, **characterized in that** for the continuous measurement of the standard-compliant lamp until the standard-compliant lamp reaches the stable state, a measurement time $t_1$ is at least 30 minutes, and a measurement interval $\Delta t_1$ is less than 1 second; and for the continuous measurement of the lamp under test, a measurement time $t_2$ is at least 20 seconds, and a measurement interval $\Delta t_2$ is equal to the measurement interval $\Delta t_1$ for the standard-compliant lamp.

5. The luminosity compensation method according to claim 3, **characterized in that** normalizing the benchmark luminosity attenuation curve comprises:

removing a first item $E_{bench1}$ collected of the benchmark luminosity data, and normalizing remaining items $E_{bench}$ to $E_{benchh}$ of the benchmark luminosity data using the following formula:

$$E_{bench-norm_{n-1}} = E_{bench_n} \Big/ E_{bench_2}$$

wherein $E_{bench-normn-1}$ represents normalized data, n is a positive integer, $1<n\leq L_1$, and $L_1$ represents a total number of items of the benchmark luminosity data, indicating that a total of $L_1$-1 items of the normalized data are to be acquired; and

calculating the benchmark gradient data of the normalized data using the following formula:

$$G_{bench_N} = E_{bench-norm_{N+2}} - E_{bench-norm_{N+1}}$$

wherein $G_{benchN}$ represents an $N^{th}$ item of the benchmark gradient data acquired by the normalized data, and $1\leq N<L_1-1$.

6. The luminosity compensation method according to claim 5, **characterized in that** in the step S3, the preliminary data position is calculated using the following formula:

$$Index = \arg\min\left(\Delta G_p\right)$$

wherein Index represents a time position in the benchmark luminosity attenuation curve, $\Delta G_p$ represents a sum of squares of differences between a gradient data change sequence $G_{[L_1/2]}$ to $G_{L_1}$ of the actual luminosity data and a benchmark gradient data sequence of a corresponding length at a position p in the benchmark luminosity data, a value of p satisfies $1 \leq p < L_1 - L_2 + 1$, and $L_2$ represents a total number of items of the actual luminosity data.

7. The luminosity compensation method according to claim 6, **characterized in that** $\Delta G_p$ is calculated using the following formula:

$$\Delta G_p = \sum_{M=[L_1/2]}^{L_1} \left( G_M - G_{bench_{p+M-1}} \right)^2$$

wherein $G_M$ represents the actual gradient data, [] represents a rounding operation, $G_{benchp+M+1}$ represents a $(p+M-1)^{th}$ item of the benchmark gradient data acquired by the normalized data, and $G_M$ is expressed as $G_M = E_{normM+1} - E_{normM}$, wherein $1 \leq M < L_2$, $E_{normM}$ represents normalized data of the actual luminosity data $E_m$,

$$E_{norm_M} = E_m \Big/ E_2$$, m is a positive integer, and $1 < m \leq L_2$.

8. The luminosity compensation method according to claim 7, **characterized in that** in the step S4, the position compensation is performed on the preliminary data position using the following formula:

$$Index_{compen} = Index + \left[ a \times e^{b(\Delta s - c)} \right]$$

wherein a, b, and c are constants, and $\Delta s$ represents a variable introduced for luminosity compensation and is expressed as:

$$\Delta s = \sum_{m=1}^{L_2} \left( E_m - E_{bench_{Index+m}} \right)$$

wherein $E_{benchIndex+m}$ represents an $(Index+m)^{th}$ item of the benchmark luminosity data.

9. The luminosity compensation method according to claim 8, **characterized in that** after the final data position $Index_{compen}$ is acquired, an actual final luminosity value at a moment T is calculated using the following formula:

$$E_T = \frac{E_{bench_T}}{E_{bench_{Index_{compen}}}} \times E_{last}$$

wherein $E_T$ represents an actual luminosity value of the lamp under test measured at the moment T, $E_{benchT}$ represents benchmark luminosity data of the standard-compliant lamp at the moment T, $E_{bench_{Index_{compen}}}$ represents benchmark luminosity data of the standard-compliant lamp at the final data position $Index_{compen}$, and $E_{last}$ represents actual luminosity data of the lamp under test acquired by a last measurement among continuous measurements.

Acquire reference test data Data1 of a standard-compliant lamp ~S1

Acquire actual test data Data2 of a lamp under test ~S2

Fit and align the reference test data Data1 and the actual test data Data2 to obtain a preliminary data position in the reference test data Data1 that best matches the actual test data Data2 ~S3

Perform position compensation on the preliminary data position to obtain a final data position ~S4

Determine a final luminosity value of the lamp under test according to the final data position ~S5

FIG. 1

FIG. 2

FIG. 3

FIG. 4

FIG. 5

Time (s)

FIG. 6

Time (s)

FIG. 7

FIG. 8

## INTERNATIONAL SEARCH REPORT

| International application No. |
| --- |
| **PCT/CN2023/108302** |

### A. CLASSIFICATION OF SUBJECT MATTER

G01M11/06(2006.01)i; G01R31/44(2020.01)i; G01R1/04(2006.01)i

According to International Patent Classification (IPC) or to both national classification and IPC

### B. FIELDS SEARCHED

Minimum documentation searched (classification system followed by classification symbols)

IPC: G01M G01R

Documentation searched other than minimum documentation to the extent that such documents are included in the fields searched

Electronic data base consulted during the international search (name of data base and, where practicable, search terms used)

CNABS; CNTXT; CNKI; 万方, WANFANG; 超星, CHAOXING; VEN; USTXT; EPTXT; WOTXT; IEEE: 灯, 光度, 补偿, 标准, 合格, 曲线, 匹配, 时间, 时刻, 效率, lamb, light, intensity, compensation, standard, curve, mate, time, efficient

### C. DOCUMENTS CONSIDERED TO BE RELEVANT

| Category* | Citation of document, with indication, where appropriate, of the relevant passages | Relevant to claim No. |
| --- | --- | --- |
| PX | CN 116046354 A (CHANGZHOU XINGYU AUTOMOTIVE LIGHTING SYSTEMS CO., LTD.) 02 May 2023 (2023-05-02)<br>  claims 1-9 | 1-9 |
| X | CN 107544037 A (GUANGZHOU GUJIA LAMP TECHNOLOGY CO., LTD.) 05 January 2018 (2018-01-05)<br>  claims 1-4, description, paragraphs [0001]-[0025], and figure 1 | 1 |
| A | CN 105300659 A (SHANGHAI ALPHA LIGHTING EQUIPMENT TESTING LTD. et al.) 03 February 2016 (2016-02-03)<br>  entire document | 1-9 |
| A | US 7797117 B1 (MUSCO CORP.) 14 September 2010 (2010-09-14)<br>  entire document | 1-9 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **15 September 2023** | **02 October 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

| International application No. |
| --- |
| **PCT/CN2023/108302** |

| Patent document cited in search report | | | Publication date (day/month/year) | Patent family member(s) | Publication date (day/month/year) |
| --- | --- | --- | --- | --- | --- |
| CN | 116046354 | A | 02 May 2023 | None | |
| CN | 107544037 | A | 05 January 2018 | None | |
| CN | 105300659 | A | 03 February 2016 | None | |
| US | 7797117 | B1 | 14 September 2010 | None | |

Form PCT/ISA/210 (patent family annex) (July 2022)